# EUROPEAN PATENT APPLICATION

(11) **EP 4 787 468 A1**
(43) Date of publication of application: **05.08.2026**
(21) Application number: 24872795.0
(22) Date of filing: 11.09.2024
(51) Int. Cl.: H01M 4/36, H01M 4/131, H01M 4/525, H01M 10/052, C30B 29/22, C01G 53/00, H01M 4/02

(54) **CATHODE ACTIVE MATERIAL FOR LITHIUM SECONDARY BATTERY, PREPARATION METHOD THEREFOR, AND LITHIUM SECONDARY BATTERY COMPRISING SAME**

(30) Priority: 25.09.2023 KR 20230128430
(71) Applicant: Posco Future M Co., Ltd., Pohang-si, Gyeongsangbuk-do 37918 (KR)
(72) Inventor: LEE, Seungwon, Pohang-si, Gyeongsangbuk-do 37918 (KR); MYUNG, Minhoon, Pohang-si, Gyeongsangbuk-do 37918 (KR); LEE, Subin, Pohang-si, Gyeongsangbuk-do 37918 (KR)
(74) Representative: Pfenning, Meinig & Partner mbB
(86) International application number: PCT/KR2024/013839
(87) International publication number: WO 2025/071087

(57) **Abstract**

The present embodiments relate to a positive electrode active material for a lithium secondary battery, a method for manufacturing the same, and a lithium secondary battery including the same. In an embodiment, the positive electrode active material for a lithium secondary battery may include a single-particle metal oxide and a coating layer disposed on a surface of the metal oxide, wherein the coating layer includes particle-type compounds containing a coating element, and an area of the coating layer comprising the particle-type compounds may be 35% or greater based on an entire surface area of the metal oxide.

## Description

### [Technical Field]

The present embodiments relate to a positive electrode active material for a lithium secondary battery, a method for manufacturing the same, and a lithium secondary battery including the same.

### [Background Art]

Recently, driven by the explosive growth in demand for electric vehicles and the need for extended driving range, development of secondary batteries having high capacity and high energy density has been actively pursued worldwide.

As a measure to satisfy such requirements, technologies employing high-nickel NCM positive electrode materials having a high Ni content and configured in the form of secondary particles have been proposed.

However, as the nickel content increases, particle strength decreases, which leads to the generation of microcracks during charge and discharge. This results in an increase in the specific surface area of the positive electrode material, thereby causing increased side reactions with the electrolyte and consequently increased gas generation. In addition, due to the weak strength of secondary particles, the secondary particles fracture during the electrode rolling process, increasing the amount of fines and causing deterioration of the battery lifespan characteristics.

To address these issues, an approach has been proposed in which the size of primary particles is maximized so that the positive electrode material is manufactured in a single-particle form, thereby reducing the specific surface area and increasing particle strength.

However, in general, manufacturing a positive electrode material in a single-particle form requires calcination at temperatures higher than those used for secondary-particle materials, and such high-temperature calcination often results in over-sintering, which induces crystal defects in the layered structure and causes degradation of output and lifespan characteristics.

### [Detailed Description of the Invention]

### [Technical Problem]

The present embodiments aim to provide a positive electrode active material for a lithium secondary battery having excellent output and lifespan characteristics, a method for manufacturing the same, and a lithium secondary battery including the same.

### [Technical Solution]

According to an embodiment of the present invention, a positive electrode active material for a lithium secondary battery may include a single-particle metal oxide and a coating layer disposed on a surface of the metal oxide, wherein the coating layer includes particle-type compounds containing a coating element, and an area of the coating layer comprising the particle-type compounds may be 35% or greater based on an entire surface area of the metal oxide.

A method for manufacturing a positive electrode active material for a lithium secondary battery according to another embodiment may include: preparing a metal hydroxide comprising nickel, cobalt, and manganese; mixing the metal hydroxide with a lithium raw material and a doping raw material to prepare a mixture; calcining the mixture to obtain a single-particle calcined product; and mixing the calcined product with a coating raw material and performing heat treatment to obtain a metal oxide having a coating layer formed thereon, wherein the coating raw material may include particle-type compounds having an average particle diameter of 150 nm to 300 nm.

A positive electrode for a lithium secondary battery according to yet another embodiment may include the positive electrode active material according to any of the embodiments.

A lithium secondary battery according to another embodiment may include the positive electrode for a lithium secondary battery according to any of the embodiments.

### [Effects of the Invention]

According to the present embodiments, by allowing the coating layer comprising the particle-type compounds to occupy 35% or more of the entire surface area of the single-particle metal oxide, crystal defects in the layered structure can be prevented.

Accordingly, when the positive electrode active material of the present embodiments is applied, a lithium secondary battery having excellent output characteristics and high-temperature lifespan characteristics can be implemented.

### [Brief Description of the Drawings]

FIG. 1 is an enlarged SEM-EDS image showing a cross-section of the positive electrode active material prepared in Example 1.
FIG. 2 is an image (×50,000 magnification) obtained by mapping cobalt (Co) using an EDS instrument for the positive electrode active material prepared in Example 1 and identifying cobalt compounds present on the surface.
FIG. 3 is a diagram showing the line-scanning results measured using an EDS instrument for the positive electrode active material prepared in Example 1.

### [Best Mode for Carrying Out the Invention]

The terms such as first, second, and third are used to describe various parts, components, regions, layers, and/or sections, but are not limited thereto. These terms are merely used to distinguish one part, component, region, layer, or section from another. Therefore, a first part, component, region, layer, or section described below may be referred to as a second part, component, region, layer, or section within the scope of the present invention without departing from the spirit of the invention.

Technical terms used herein are intended only to describe specific embodiments and are not intended to limit the present invention. Singular forms used herein include plural forms unless the context clearly indicates otherwise. The term "comprising/including/containing" as used in this specification, specifies the presence of stated features, regions, integers, steps, operations, elements, and/or components, and does not preclude the presence or addition of one or more other features, regions, integers, steps, operations, elements, and/or components.

When a part is referred to as being "on" or "over/above" another part, it may be directly on or over the other part, or one or more intervening parts may be present between them. In contrast, when a part is referred to as being "directly on" or "directly over/above" another part, no intervening part is present therebetween.

Unless otherwise defined, all terms including technical and scientific terms used herein have the same meaning as commonly understood by one of ordinary skill in the art to which the present invention pertains. Terms generally defined in dictionaries shall be interpreted as consistent with the relevant technical literature and the present disclosure, and shall not be interpreted in an idealized or overly formal sense unless expressly defined herein.

Unless otherwise specified, "%" represents weight percent (wt%), and 1 ppm means 0.0001 wt%.

In this specification, the term "combinations thereof" recited in a Markush expression refers to mixtures or combinations of one or more components selected from the group consisting of the components described in the Markush expression, and includes one or more components selected from the group.

Hereinafter, embodiments of the present invention will be described in detail so that those skilled in the art to which the present invention pertains can readily carry out the invention. However, the present invention may be embodied in many different forms and is not limited to the embodiments described herein.

### Lithium Secondary Battery Positive Electrode Active Material

As described above, a single-particle-type positive electrode active material tends to suffer from decreased output and high-temperature cycle characteristics because oversintering may occur during high-temperature calcination, thereby generating defects in the layered crystal structure. However, in the present embodiment, such problems were resolved by providing, on the surface of a single-particle-type metal oxide, a coating layer including a particle-type compound containing a coating element, wherein the coating layer occupies a specific minimum area fraction of the metal oxide surface.

Specifically, a positive electrode active material for a lithium secondary battery according to one embodiment includes a single-particle metal oxide; and a coating layer located on a surface of the metal oxide, wherein the coating layer includes a particle-type compound containing a coating element, and an area of the coating layer including the particle-type compound may be 35% or more based on the entire surface area of the metal oxide.

The area of the coating layer including the particle-type compound may be from 35% to 50%, or from 36% to 45%, based on the entire surface area of the metal oxide.

As used herein, the term "single particle" refers to a structure that is distinguished as a single mass when observing a cross-section of a powder through a scanning electron microscope (SEM), and includes at least one structure selected from: a structure that is a single crystal composed of a single particle; and a structure in which about 2 to 20, or 2 to 10, particles are agglomerated together. Here, one particle corresponds to one grain (grain or crystallite).

The single-particle-type active material of the present embodiment has advantages over conventional secondary-particle-type active materials, in which tens to hundreds of primary particles are agglomerated. For example, the single-particle structure has a smaller specific surface area, thereby reducing gas generation caused by side reactions with the electrolyte; has a higher particle strength, thereby suppressing particle breakage during electrode calendaring; and reduces crack formation during repeated charge/discharge cycling. As a result, compared with secondary-particle materials, the single-particle-type active material exhibits improved lifetime and safety and enables higher electrode energy density.

The coating layer may include a particle-type compound containing a coating element, and the average particle size of the particle-type compound may be 50 nm to 300 nm, or 100 nm to 200 nm. When the average particle size falls within the above range, the coating layer can be formed uniformly.

In addition, the coating element included in the particle-type compound may be diffused from the surface of the metal oxide-the surface on which the coating layer is formed-toward the center direction to a depth of 75 nm or more, and more specifically to a thickness range of 75 nm to 180 nm, or 80 nm to 170 nm. When the coating element is diffused within the above thickness range, excellent high-temperature cycle characteristics may be achieved.

In this embodiment, the particle-type compound containing the coating element may include at least one selected from CoO, Co₂O₃, Co₃O₄, LiCoO₂, Co(OH)₂, CoCl₂, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, and Co₃(PO₄)₂.

As described above, since the single-particle-type positive electrode active material is generally manufactured via higher-temperature calcination than secondary-particle materials, defects such as increased cation mixing may occur in the layered structure. In the present embodiment, the formation of a coating layer containing the above particle-type compound on the surface of the metal oxide can suppress crystal defects such as increased cation mixing during high-temperature calcination and can allow efficient growth of crystallite size within the single particle as well as an increase in the average particle size of the single particle.

The content of the coating element included in the particle-type compound within the coating layer may be from 0.035 mol to 0.08 mol, and more specifically from 0.05 mol to 0.07 mol, based on 1 mol of total transition metals included in the metal oxide on which the coating layer is formed. In this embodiment, the coating element contained in the particle-type compound may be cobalt. When the content of cobalt satisfies the above range, the crystallite size can be grown to an appropriate level, and the production cost can be appropriately controlled, thereby providing excellent economic advantages.

The coating layer may further include an additional coating element, and the additional coating element may include, for example, aluminum.

Meanwhile, the metal oxide of the present embodiment may include nickel, cobalt, and manganese. In this case, the nickel content may be 0.8 mol or more, and more specifically 0.8 mol to 0.99 mol, 0.82 mol to 0.95 mol, or 0.82 mol to 0.93 mol, based on 1 mol of a total of nickel, cobalt, and manganese. When the nickel content satisfies the above range, a high-capacity cell can be realized.

The cobalt content may be 0.05 mol or less, and more specifically greater than 0 and 0.05 mol or less, based on 1 mol of a total of nickel, cobalt, and manganese.

The manganese content may be 0.1 mol or less, and more specifically from 0.05 mol to 0.1 mol, based on 1 mol of a total of nickel, cobalt, and manganese.

The metal oxide may further include a doping element. The doping element may include at least one selected from Y, Al, Zr, Nb, Mo, W, Ti, Ce, Mg, B, P, V, and Sr. In this embodiment, the doping element may include, for example, Y, Al, and Zr.

The content of the doping element may be from 0 to 0.2 mol, and more specifically from 0.0005 mol to 0.1 mol, 0.0005 mol to 0.08 mol, 0.0005 mol to 0.04 mol, or 0.001 mol to 0.03 mol, based on 1 mol of a total of nickel, cobalt, manganese, and the doping element. Specifically, based on the total amount of nickel, cobalt, manganese, and the doping element, the content of Y may be 400 ppm to 2,000 ppm, Al may be 200 ppm to 1,800 ppm, and Zr may be 1,200 ppm to 2,800 ppm.

In this embodiment, the content of the doping element refers to the amount of the doping element included in the final obtained positive electrode active material.

### Manufacturing Method of the Positive Electrode Active Material for a Lithium Secondary Battery

In another embodiment, a method of manufacturing a positive electrode active material for a lithium secondary battery is provided, the method comprising: preparing a metal hydroxide including nickel, cobalt, and manganese; preparing a mixture by mixing the metal hydroxide, a lithium raw material, and a doping raw material; calcining the mixture to obtain a single-particle-type calcined material; and mixing the calcined material with a coating raw material followed by heat treatment to obtain a metal oxide having a coating layer formed thereon, wherein the coating raw material includes a particle-type compound having an average particle diameter of 150 nm to 300 nm.

The step of preparing the metal hydroxide including nickel, cobalt, and manganese may be performed, for example, by preparing an aqueous metal salt solution including a nickel raw material, a cobalt raw material, a manganese raw material, and distilled water, and supplying the aqueous metal salt solution to a co-precipitation reactor to produce the metal hydroxide. Such a process may be carried out according to a generally known method for preparing metal hydroxides.

The nickel raw material may include, for example, a nickel-containing sulfate, acetate, nitrate, halide, sulfide, hydroxide, oxide, or oxyhydroxide. More specifically, the nickel raw material may include NiSO₄, NiSO₄·6H₂O, Ni(OH)₂, NiO, NiOOH, NiCO₃·2Ni(OH)₂·4H₂O, NiC₂O₂·2H₂O, Ni(NO₃)₂·6H₂O, a nickel fatty acid salt, a nickel halide, or a combination thereof.

The cobalt raw material may include, for example, a cobalt-containing sulfate, acetate, nitrate, halide, sulfide, hydroxide, oxide, or oxyhydroxide. More specifically, the cobalt raw material may include CoSO₄, CoSO₄·7H₂O, Co(OH)₂, CoOOH, Co(OCOCH₃)₂·4H₂O, Co(NO₃)₂·6H₂O, or a combination thereof.

The manganese raw material may include, for example, a manganese-containing sulfate, acetate, nitrate, halide, sulfide, hydroxide, oxide, oxyhydroxide, or a combination thereof. More specifically, the manganese raw material may include manganese salts such as MnSO₄, MnSO₄·H₂O, MnCO₃, Mn(NO₃)₂, manganese acetate, manganese dicarboxylate, manganese citrate, and manganese fatty acid salts; manganese oxides such as Mn₂O₃, MnO₂, and Mn₃O₄; manganese oxyhydroxide; manganese chloride; or a combination thereof.

Next, the step of preparing the mixture is performed by mixing the metal hydroxide, the lithium raw material, and the doping raw material.

The lithium raw material may include, for example, lithium-containing sulfates, nitrates, acetates, carbonates, oxalates, citrates, halides, hydroxides, or oxyhydroxides, without limitation so long as they are soluble in water. More specifically, the lithium raw material may include LiOH, Li₂CO₃, LiNO₃, LiNO₂, LiOH·H₂O, LiH, LiF, LiCl, LiBr, LiI, CH₃COOLi, Li₂O, Li₂SO₄, CH₃COOLi, Li₃C₆H₅O₇, or a combination thereof.

In the mixture, the molar ratio (Li/Me) of lithium (Li) to the total metals (Me) excluding lithium may be in the range of 1.0 to 1.1, or 1.01 to 1.08.

The doping raw material may include at least one raw material selected from Al, Zr, Nb, Mo, W, Ti, Ce, Mg, B, P, V, Sr, and B. More specifically, the doping raw material may include an Al raw material, a Y raw material, and a Zr raw material.

The Al raw material may include at least one selected from Al(OH)₃, Al₂(SO₄)₃, Al(NO)₃, Al₂O₃, and AlCl₃.

The Y raw material may include at least one selected from Y₂O₃, Y(SO₄)₂, Y₂(SO₄)₃, and Y(NO₃)₃.

The Zr raw material may include at least one selected from ZrO₂, Zr(SO₄)₂, ZrS₂, and Zr(NO₃)₄.

Subsequently, the mixture is calcined to obtain the single-particle-type calcined material.

In this embodiment, the step of obtaining the calcined material may be performed through a three-step calcination process including a first-step calcination, a second-step calcination, and a third-step calcination.

Specifically, the first-step calcination may be performed at 870°C to 930°C for 2 hours to 6 hours, or at 880°C to 920°C for 3 hours to 5 hours.

The second-step calcination may be performed at 890°C to 960°C for 0.5 hour to 2 hours, or at 900°C to 940°C for 0.5 hour to 1.5 hours.

The third-step calcination may be performed at 750°C to 870°C for 5 hours to 14 hours, or at 780°C to 840°C for 7 hours to 12 hours.

If necessary, a pre-calcination step may be performed prior to the three-step calcination.

Next, the step of mixing the calcined material with the coating raw material followed by heat treatment is performed to obtain the metal oxide having the coating layer formed thereon.

The heat treatment may be performed at 700°C to 800°C for 3 hours to 10 hours.

In this embodiment, the coating raw material may include a particle-type compound having an average particle diameter of 150 nm to 300 nm, or 200 nm to 280 nm.

The coating raw material including the particle-type compound may include at least one selected from Co(OH)₂, CoCl₂, CoO, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, Co₃(PO₄)₂, or combinations thereof.

The coating raw material including the particle-type compound may be added in an amount of 1.5 mol% to 3 mol%, or 2.0 mol% to 2.8 mol%, based on 100 g of the calcined material.

In addition to the particle-type compound, the coating raw material may further include an additional coating raw material. The additional coating raw material may include at least one selected from Al(OH)₃, Al₂(SO₄)₃, Al(NO)₃, Al₂O₃, and AlCl₃.

The additional coating raw material may be added in an amount of 500 ppm to 1,500 ppm based on the total weight of the calcined material.

According to the present embodiment, the use of a coating raw material including a particle-type compound having an average particle size of 150 nm to 300 nm enables stabilization of the layered crystal structure of the single-particle-type positive electrode active material, thereby achieving a positive electrode active material exhibiting excellent high-temperature cycle performance.

### Positive electrode

In another embodiment, a positive electrode is provided, the positive electrode comprising a current collector and a positive electrode active material layer disposed on one surface of the current collector, the positive electrode active material layer including the positive electrode active material prepared according to the above-described embodiment.

The characteristics of the positive electrode active material included in the positive electrode active material layer are the same as previously described, and therefore, a detailed description thereof will be omitted.

The current collector may include, for example, stainless steel, aluminum, nickel, titanium, calcined carbon, or a surface-treated material in which carbon, nickel, titanium, or silver is coated on a surface of aluminum or stainless steel.

The positive electrode active material layer may further include a binder and a conductive agent.

The binder functions to enhance adhesion between particles of the positive electrode active material and adhesion between the positive electrode active material and the current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer (EPDM) rubber, sulfonated EPDM, styrene-butadiene rubber (SBR), fluororubber, or various copolymers thereof. One or a combination of two or more of the above may be used, without limitation. The binder may be included in an amount of 1 wt% to 30 wt% based on the total weight of the positive electrode active material layer.

The conductive agent is used to impart electrical conductivity to the electrode and may be any material that exhibits electronic conductivity without causing chemical changes in the cell. Specific examples include carbon materials such as natural graphite, artificial graphite, carbon black, acetylene black, Ketjen black, channel black, furnace black, lamp black, thermal black, and carbon fibers; metal powders or metal fibers such as copper, nickel, aluminum, and silver; conductive whiskers such as zinc oxide and potassium titanate; conductive metal oxides such as titanium oxide; or conductive polymers such as polyphenylene derivatives. One or a combination of two or more of the above may be used, without limitation. The conductive agent may be included in an amount of 1 wt% to 30 wt% based on the total weight of the positive electrode active material layer.

The positive electrode may be manufactured according to conventional positive electrode fabrication methods, except that the positive electrode active material described above is used.

Specifically, the positive electrode may be prepared by applying a positive electrode active material layer-forming composition including the positive electrode active material and, optionally, a binder, a conductive agent, and a solvent, onto the current collector, followed by drying and calendaring. In this case, the types and contents of the positive electrode active material, binder, and conductive agent are as described above.

The solvent may be any solvent commonly used in the art, such as dimethyl sulfoxide (DMSO), isopropyl alcohol, N-methyl-2-pyrrolidone (NMP), acetone, or water, and one or a mixture of two or more may be used. The amount of solvent is sufficient to dissolve or disperse the positive electrode active material, conductive agent, and binder so as to have a viscosity that provides uniform coating thickness during application, considering slurry coating thickness and manufacturing yield.

Alternatively, the positive electrode may be manufactured by casting the positive electrode active material layer-forming composition onto a separate support, peeling a resulting film from the support, and laminating the film onto the current collector.

### Lithium Secondary Battery

In another embodiment, the present invention provides a lithium secondary battery comprising the positive electrode described above.

Specifically, the lithium secondary battery may include a positive electrode, a negative electrode disposed opposite to the positive electrode, a separator interposed between the positive electrode and the negative electrode, and an electrolyte, wherein the positive electrode is as described previously. The lithium secondary battery may further optionally include a battery case accommodating an electrode assembly composed of the positive electrode, negative electrode, and separator, and a sealing member for sealing the battery case.

In the lithium secondary battery, the negative electrode may include a negative electrode current collector and a negative electrode active material layer disposed on the negative electrode current collector.

The negative electrode current collector is not particularly limited as long as it possesses high conductivity without causing chemical changes in the battery. Examples include copper, stainless steel, aluminum, nickel, titanium, sintered carbon, copper or stainless steel surface-treated with carbon, nickel, titanium, or silver, and aluminum-cadmium alloys. The negative electrode current collector generally may have a thickness of 3 to 500 µm, and, similar to the positive electrode current collector, may have fine surface irregularities formed thereon to enhance the adhesion of the negative electrode active material. For example, it may be used in various forms such as films, sheets, foils, nets, porous bodies, foams, or nonwoven fabrics.

The negative electrode active material layer may include a negative electrode active material and optionally a binder and/or a conductive material. The negative electrode active material layer may be manufactured, for example, by applying and drying a composition for forming a negative electrode active material layer, which includes a negative electrode active material and optionally a binder and a conductive material, on the negative electrode current collector, or alternatively, by casting the composition on a separate support, peeling off the resulting film, and laminating the film onto the negative electrode current collector.

As the negative electrode active material, a compound capable of reversibly intercalating and deintercalating lithium may be used. Specific examples include carbon-based materials such as artificial graphite, natural graphite, graphitized carbon fiber, and amorphous carbon; metallic compounds capable of forming alloys with lithium such as Si, Al, Sn, Pb, Zn, Bi, In, Mg, Ga, Cd, and alloys thereof; metal oxides capable of doping and dedoping lithium such as SiOβ (0 < β < 2), SnO₂, vanadium oxide, and lithium vanadium oxide; and composites including the above metallic compounds and carbon materials such as Si-C composites and Sn-C composites. Any one or a combination of two or more of these materials may be used. A thin film of metallic lithium may also be used as the negative electrode active material.

Carbon materials may include both low-crystallinity and high-crystallinity carbons. Examples of low-crystallinity carbon include soft carbon and hard carbon. Examples of high-crystallinity carbon include amorphous, flake-like, platelet-like, spherical, or fibrous natural graphite or artificial graphite, kish graphite, pyrolytic carbon, mesophase pitch-based carbon fiber, mesocarbon microbeads, mesophase pitches, and high-temperature fired carbon such as petroleum or coal tar pitch-derived coke.

The binder and conductive material may be the same as those described for the positive electrode.

Depending on the type of lithium secondary battery, a separator may be interposed between the positive electrode and the negative electrode. Such a separator may include polyethylene, polypropylene, polyvinylidene fluoride, or a multilayer film of two or more layers thereof. Examples of mixed multilayer separators include polyethylene/polypropylene bilayer separators, polyethylene/polypropylene/polyethylene trilayer separators, and polypropylene/polyethylene/polypropylene trilayer separators.

The electrolyte used in the lithium secondary battery may include an organic liquid electrolyte, an inorganic liquid electrolyte, a solid polymer electrolyte, a gel-type polymer electrolyte, a solid inorganic electrolyte, or a molten inorganic electrolyte, but is not limited thereto.

Specifically, the organic liquid electrolyte may include an organic solvent and a lithium salt. The organic solvent may be any medium capable of allowing ions involved in the electrochemical reactions of the battery to move. Examples of the organic solvent include ester-based solvents such as methyl acetate, ethyl acetate, γ-butyrolactone, and ε-caprolactone; ether-based solvents such as dibutyl ether and tetrahydrofuran; ketone-based solvents such as cyclohexanone; aromatic hydrocarbon-based solvents such as benzene and fluorobenzene; carbonate-based solvents such as dimethyl carbonate (DMC), diethyl carbonate (DEC), methylethyl carbonate (MEC), ethylmethyl carbonate (EMC), ethylene carbonate (EC), and propylene carbonate (PC); alcohol-based solvents such as ethanol and isopropanol; nitriles such as R-CN (where R is a C₂-C₂₀ linear, branched, or cyclic hydrocarbon group optionally containing a double bond, aromatic ring, or ether linkage); amides such as dimethylformamide; dioxolanes such as 1,3-dioxolane; and sulfolanes. Among these, carbonate-based solvents are preferred. A mixture of cyclic carbonates with high ionic conductivity and dielectric constant (e.g., ethylene carbonate or propylene carbonate) and linear carbonates with low viscosity (e.g., ethyl methyl carbonate, dimethyl carbonate, or diethyl carbonate) is particularly preferred. In this case, the cyclic carbonate and linear carbonate may be mixed in a volume ratio of about 1:1 to about 1:9 to achieve excellent electrolyte performance.

The lithium salt may be any compound capable of providing lithium ions used in lithium secondary batteries. Specific examples include LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, and LiB(C₂O₄)₂. The concentration of the lithium salt is preferably within the range of 0.1 to 2.0 M. When the concentration of the lithium salt falls within this range, the electrolyte exhibits appropriate conductivity and viscosity, resulting in excellent electrolyte performance and effective lithium-ion transport.

As described above, the lithium secondary battery including the positive electrode active material according to the present invention exhibits excellent discharge capacity, output characteristics, and capacity retention stability. Therefore, it is highly useful for applications such as portable electronic devices (e.g., mobile phones, laptop computers, digital cameras) and in the field of electric vehicles, including hybrid electric vehicles (HEVs).

### [Mode for Carrying Out the Invention]

Hereinafter, embodiments of the present invention will be described in detail. However, these embodiments are provided only as illustrative examples, and the present invention is not limited thereto, but is defined only by the scope of the claims described below.

### Example 1

### (1) Preparation of Positive Electrode Active Material

A precursor having a composition of Ni_{0.90}Co_{0.03}Mn_{0.07}(OH)₂ was first prepared. LiOH·H₂O (Samjeon Chemicals, battery grade) was uniformly mixed with the precursor as a lithium raw material, and Y₂O₃, ZrO₂, and Al(OH)₃ were uniformly mixed as doping raw materials to prepare a mixture.

At this time, the molar ratio of lithium (Li) to total metal (Me), excluding lithium, was designed to be Li/Me = 1.05.

In addition, the doping raw materials were added such that, based on the precursor, the doping amounts became 2000 ppm of Zr, 1200 ppm of Y, and 1000 ppm of Al.

The resulting mixture was introduced into a calcination furnace under an oxygen atmosphere and pre-calcined at 680°C for 6.5 hours to obtain a pre-calcined material.

Next, the obtained pre-calcined material was introduced into a calcination furnace under an oxygen atmosphere and calcined by a 3-step process:
**1st step:** 890°C for 3 hours
**2nd step:** 940°C for 1 hour
**3rd step:** 780°C for 11 hours

Through this 3-step calcination, a calcined product was obtained.

The calcined product was then crushed to obtain a single-particle-type metal oxide doped with Al, Y, and Zr.

The obtained single-particle-type metal oxide was then dry-mixed with Co(OH)₂ and Al(OH)₃ as coating raw materials, followed by heat treatment at 700°C for 5 hours under an oxygen atmosphere to form a coating layer, thereby preparing a coated positive electrode active material.

In this process, Co(OH)₂ having an average particle size of 247 nm was used as the coating raw material.

Co(OH)₂ and Al(OH)₃ were mixed such that, based on the single-particle-type metal oxide, the Co content corresponded to 2.5 mol% and the Al content corresponded to 1000 ppm.

### Examples 2-3 and Comparative Examples 1-2

Except for adjusting the average particle size of the coating raw material and the heat treatment temperature for forming the coating layer as shown in Table 1 below, the positive electrode active materials were prepared in the same manner as in Example 1.

**[Table 1]**

| Sample | Particle Size of Co Raw Material (nm) | Heat-Treatment Temperature (°C) |
|---|---|---|
| Example 1 | 247 | 700 |
| Example 2 | 235 | 750 |
| Example 3 | 242 | 800 |
| Comparative Example 1 | 551 | 700 |
| Comparative Example 2 | 522 | 750 |

### Experimental Example 1 - EDS (Energy Dispersive X-ray Spectroscopy) Analysis

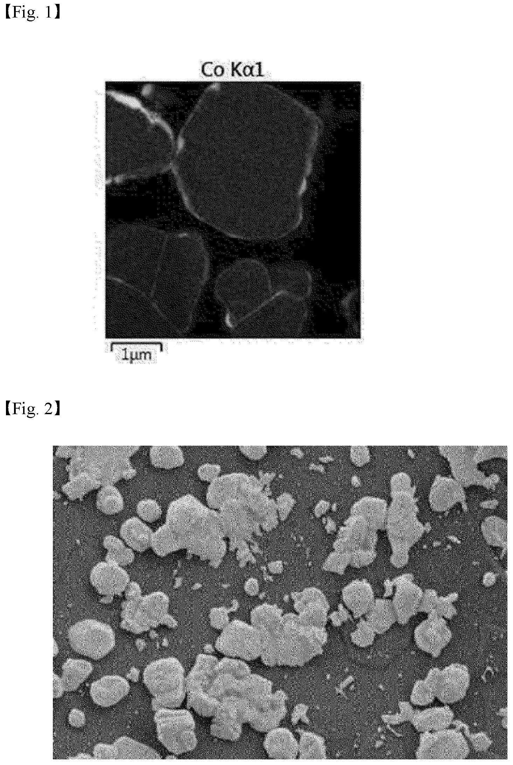

FIG. 1 is an SEM-EDS image obtained by magnifying and observing the cross-section of the positive electrode active material prepared in Example 1.

FIG. 2 is an image (magnification: 50,000×) showing cobalt-containing compounds present on the surface of the positive electrode active material prepared in Example 1, obtained by mapping the Co element using an EDS instrument.

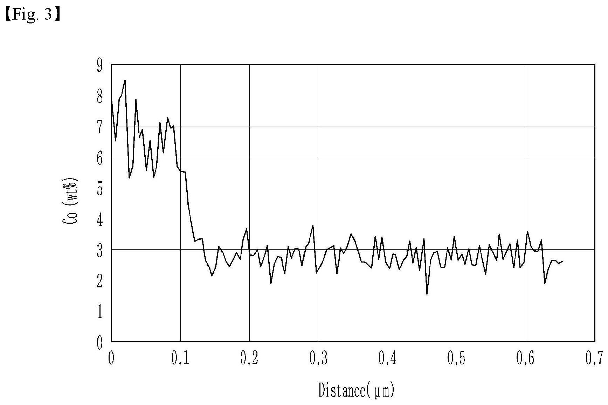

FIG. 3 shows the line-scanning results measured using an EDS instrument for the positive electrode active material prepared in Example 1.

Referring to FIG. 1, it can be confirmed that cobalt is present inside the surface portion (multi-faceted outer region) of the positive electrode active material prepared in Example 1.

Referring to FIG. 2, it can be seen that cobalt-containing compounds in the form of particles are formed on the surface of the positive electrode active material prepared in Example 1, and that these cobalt-containing surface particles are distributed at a level of 43% or more.

Referring to FIG. 3, it can be confirmed that, at a position approximately 120 nm from the surface of the metal oxide toward the particle center, particle-type compounds containing cobalt are present.

Next, for the positive electrode active materials prepared in Examples 1 to 3 and Comparative Examples 1 to 2, the particle-type compounds containing the coating element were identified by EDS mapping, and their size and distribution ratio (i.e., coating-layer area) were measured. Furthermore, using EDS line scanning, the diffusion thickness of the coating element from the metal oxide surface was determined.

Each result is shown in Table 2 below.

**[Table 2]**

| Sample | Particle Size of Co-Containing Compound (nm) | Co Diffusion Thickness (nm) | Distribution Ratio of Particle-Type Compounds Containing Co (%) |
|---|---|---|---|
| Example 1 | 120 | 90 | 43.2 |
| Example 2 | 130 | 120 | 40.1 |
| Example 3 | 150 | 150 | 38.5 |
| Comparative Example 1 | 350 | 65 | 18.4 |
| Comparative Example 2 | 370 | 72 | 20.6 |

Referring to Table 2, it can be seen that the particle size of the coating-element-containing particles located on the surfaces of the positive electrode active materials prepared in Examples 1 to 3 is in the range of 50 nm to 300 nm, and that the distribution ratio of the particle-type compounds containing the coating element is 35% or more.

In addition, the diffusion thickness of the coating element from the surface of the metal oxide is also 75 nm or greater in Examples 1 to 3.

Accordingly, it can be understood that by appropriately controlling the particle size of the coating source, the coating element can diffuse from the surface of the metal oxide toward the particle center to a deeper region, and the coating-layer formation area also becomes larger.

### Experimental Example 2: Fabrication of Coin Cell and Evaluation of High-Temperature Capacity Retention

### (1) Fabrication of Coin Cell

Coin-type half-cells (CR2032) were fabricated using the positive electrode active materials prepared in the Examples and Comparative Examples as follows.

Specifically, the positive electrode active material, a conductive material (acetylene black FX35, Denka Co.), and a polyvinylidene fluoride (PVDF) binder (product name: KF9709) were mixed at weight ratios of 96.5 : 1.5 : 2 or 95 : 2.2 : 2.8.

The mixture was added to an N-methyl-2-pyrrolidone (NMP) solvent such that the solid content became approximately 65-69 wt%, thereby preparing a positive electrode slurry.

The slurry was coated onto an aluminum foil (Al foil, thickness: 20 µm), serving as the positive electrode current collector, using a doctor blade. After drying and roll-pressing, a positive electrode was obtained. The loading amount of the positive electrode was approximately 15-16 mg/cm², and the roll-pressed density was approximately 3.5 g/cm³.

A 2032 coin-type half-cell was then fabricated in a conventional manner using the positive electrode, a lithium metal negative electrode (thickness: 400 µm, NEBA), an electrolyte, and a polypropylene/polyethylene separator.

The electrolyte was prepared by dissolving 1 M LiPF₆ in a mixed solvent of ethylene carbonate (EC), dimethyl carbonate (DMC), and diethyl carbonate (DEC) (volume ratio EC:DMC:DEC = 1:2:1), followed by adding 2 wt% vinylene carbonate (VC).

### (2) Measurement of Capacity Retention

The coin-type half-cells fabricated in step (1) were aged at room temperature (25°C) for 10 hours, after which charge/discharge tests were conducted.

At 45°C, after a formation cycle of constant-current charging/discharging at 0.1C/0.1C within a voltage range of 2.5-4.25 V, constant-current charge/discharge cycling at 0.5C/1C was performed. The capacity retention was calculated based on the ratio of the discharge capacity measured in the 50th cycle to that measured in the first cycle.

The results are shown in Table 3.

**[Table 3]**

| Sample | Capacity Retention at 50 Cycles (%) |
|---|---|
| Example 1 | 94.2 |
| Example 2 | 93.7 |
| Example 3 | 93.8 |
| Comparative Example 1 | 91.5 |
| Comparative Example 2 | 91.9 |

Referring to Table 3, it can be confirmed that the high-temperature capacity retention of Examples 1 to 3 is significantly higher than that of Comparative Examples 1 and 2.

As described above, by appropriately controlling the particle size of the coating source, the coating element can diffuse from the surface of the metal oxide toward the particle center to a deeper region, and a wider coating-layer formation area can be obtained. Through this, it can be confirmed that the high-temperature lifetime characteristics of the positive electrode active material can be remarkably improved.

### (3) Measurement of Residual Lithium Content

For the positive electrode active materials prepared according to Examples 1 to 3 and Comparative Examples 1 and 2, the residual lithium content was measured using a T50 model titration system manufactured by METTLER TOLEDO.

The results are shown in Table 4 below.

**[Table 4]**

| Sample | LiOH | Li₂CO₃ | total |
|---|---|---|---|
| Example 1 | 0.125 | 0.176 | 0.301 |
| Example 2 | 0.114 | 0.186 | 0.300 |
| Example 3 | 0.117 | 0.195 | 0.312 |
| Comparative Example 1 | 0.125 | 0.262 | 0.387 |
| Comparative Example 2 | 0.115 | 0.235 | 0.350 |

Referring to Table 4, it can be confirmed that the residual lithium content of Examples 1 to 3 is significantly lower than that of Comparative Examples 1 and 2. As described above, by appropriately controlling the particle size of the coating source, the coating-layer area can be broadened, and through this, the residual lithium of the positive electrode active material can be markedly reduced.

The present invention is not limited to the foregoing Examples but may be implemented in various different forms. It will be understood by those skilled in the art that the present invention may be practiced in other specific embodiments without departing from the technical spirit or essential characteristics of the present invention. Therefore, the Examples described above are to be construed as illustrative and not restrictive in all respects.

## Claims

1. A positive electrode active material for a lithium secondary battery, comprising: a single-particle metal oxide; and
a coating layer disposed on a surface of the metal oxide;
wherein the coating layer comprises particle-type compounds containing a coating element,
and wherein an area of the coating layer comprising the particle-type compounds is 35% or greater based on an entire surface area of the metal oxide.

2. The positive electrode active material of claim 1,
wherein the area of the coating layer comprising the particle-type compounds is from 35% to 50% based on the entire surface area of the metal oxide.

3. The positive electrode active material of claim 1,
wherein the particle-type compounds have an average particle diameter of from 50 nm to 300 nm.

4. The positive electrode active material of claim 1,
wherein the coating element contained in the particle-type compounds is diffused inward from a surface of the metal oxide on which the coating layer is formed to a thickness range of 75 nm or greater.

5. The positive electrode active material of claim 1,
wherein the coating element contained in the particle-type compounds is diffused inward from the surface of the metal oxide to a thickness range of from 75 nm to 180 nm.

6. The positive electrode active material of claim 1,
wherein the particle-type compounds containing the coating element comprise at least one selected from CoO, Co₂O₃, Co₃O₄, LiCoO₂, Co(OH)₂, CoCl₂, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, and Co₃(PO₄)₂.

7. The positive electrode active material of claim 1,
wherein a content of the coating element contained in the particle-type compounds in the coating layer is from 0.035 mol to 0.08 mol based on a total amount of metals, excluding lithium, contained in the single-particle metal oxide.

8. The positive electrode active material of claim 6,
wherein the coating layer further comprises an additional coating element,
and the additional coating element comprises aluminum.

9. The positive electrode active material of claim 1,
wherein the metal oxide comprises nickel, cobalt, and manganese,
and wherein, based on 1 mol of a total of nickel, cobalt, and manganese, a content of nickel is 0.8 mol or greater.

10. The positive electrode active material of claim 9,
wherein the metal oxide further comprises a doping element,
and the doping element comprises at least one selected from Y, Al, Zr, Nb, Mo, W, Ti, Ce, Mg, B, P, V, Sr, and B.

11. A method for manufacturing a positive electrode active material for a lithium secondary battery, the method comprising:
preparing a metal hydroxide comprising nickel, cobalt, and manganese;
mixing the metal hydroxide with a lithium raw material and a doping raw material to prepare a mixture;
calcining the mixture to obtain a single-particle calcined product; and
mixing the calcined product with a coating raw material and performing heat-treatment to obtain a metal oxide having a coating layer formed thereon;
wherein the coating raw material comprises particle-type compounds having an average particle diameter of from 150 nm to 300 nm.

12. The method of claim 11,
wherein in the step of obtaining the metal oxide having the coating layer formed thereon, the heat-treatment is performed at 700°C to 800°C for 3 hours to 10 hours.

13. The method of claim 11,
wherein the coating raw material comprising the particle-type compounds contains at least one selected from Co(OH)₂, CoCl₂, CoO, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, Co₃(PO₄)₂, and combinations thereof.

14. The method of claim 11,
wherein the coating raw material further comprises an additional coating raw material,
and the additional coating raw material comprises at least one selected from Al(OH)₃, Al₂(SO₄)₃, Al(NO₃)₃, Al₂O₃, and AlCl₃.

15. The method of claim 11,
wherein the step of obtaining the calcined product comprises performing a three-step calcination including a first-step calcination, a second-step calcination, and a third-step calcination.

16. The method of claim 11,
wherein in the step of obtaining the metal oxide having the coating layer formed thereon, the coating raw material comprising the particle-type compounds is added in an amount of from 1.5 mol% to 3 mol% based on 100 g of the calcined product.

17. A positive electrode for a lithium secondary battery comprising the positive electrode active material of any one of claims 1 to 10.

18. A lithium secondary battery comprising the positive electrode of claim 17.
